## Europäisches Patentamt

(19) **European Patent Office**

**Office européen des brevets**

(11) Numéro de publication: **0 011 120**

**A1**

(12) # DEMANDE DE BREVET EUROPEEN

(21) Numéro de dépôt: **79103769.0**

(22) Date de dépôt: **03.10.79**

(51) Int. Cl.³: **H 01 L 29/72**
**H 01 L 29/36**

(30) Priorité: **09.11.78 US 959285**

(43) Date de publication de la demande:
**28.05.80 Bulletin 80 11**

(84) Etats Contractants Désignés:
**DE FR GB**

(71) Demandeur: **International Business Machines Corporation**

**Armonk, N.Y. 10504(US)**

(72) Inventeur: **Das, Gobinda**
**Orchard Road, Hopewell Junction**
**East Fishkill, New York 12533(US)**

(72) Inventeur: **Dumke, William Paul**
**124 Seven Bridges Road**
**Chappaqua, New York 10514(US)**

(72) Inventeur: **Phillips Jr., Alfred**
**37 Alpert Drive**
**Wappingers Falls, New York 12590(US)**

(74) Mandataire: **Gallois, Gerard**
**COMPAGNIE IBM FRANCE Département de Propriété Industrielle**
**F-06610 - La Gaude(FR)**

(54) **Dispositif semi-conducteur à gain de courant amélioré et son procédé de fabrication.**

(57) Le dispositif semi-conducteur présente une compensation réduite ou inexistante entre les atomes des imputetés des deux types dans la région émetteur. Pour cela la concentration des atomes de compensation dans la région émetteur est inférieure à $10^{18}$ atomes par cm³ et sur la plus grande partie de l'émetteur inférieure à $10^{17}$ atomes par cm³. Pour réaliser un tel dispositif on masque la région où sera formé l'émetteur pendant l'introduction des impuretés dans la région de base extrinsèque ou intrinseque. Le dispositif ainsi fabriqué présente un gain en courant un fréquence $f^T$ et un rendement améliore. Le procéde s'applique particuliérement aux dispositifs bipolaires.

EP 0 011 120 A1

./. ...

FIG. 3

1

# DISPOSITIF SEMI-CONDUCTEUR A GAIN DE COURANT AMELIORE ET SON PROCEDE DE FABRICATION

## Description

### Domaine technique de l'invention

La présente invention concerne des dispositifs semi-conducteurs à gain en courant continu, fréquences de coupure $f_T$ et rendement amélioré et, plus particulièrement, les transistors bipolaires.

### Etat de la technique antérieure

On sait depuis quelques temps que les caractéristiques des dispositifs bipolaires sont influencés par l'intervalle des bandes d'énergie subordonnées à la concentration comme indiqué par W.L. Kauffman et A.A. Bergh dans la revue "IEEE Trans. on Electron Devices" Vol. ED-15 p. 732 (1968).

Un modèle a été développé par la demanderesse pour inclure les effets du rétrécissement de l'intervalle des bandes d'énergie dans les conceptions de dispositifs bipolaires ce qui a permis, pour la première fois, des calculs précis de tous les paramètres de dispositif, mesurés à température ambiante, d'un transistor npn moderne à performances élevées. Les calculs de $\beta$ (gain en courant), de $f_T$ (fréquence de largeur de bande de gain en courant) et la subordination du courant du collecteur à la résistance de feuille de la base correspondent aux mesures effectuées lorsque les effets du rétrécissement de l'intervalle des bandes d'énergie subordonnées à la concentration sont inclus d'une manière particulière.

Le rétrécissement de l'intervalle des bandes d'énergie est inclus dans les conceptions de dispositifs bipolaires en remplaçant la concentration des porteurs du matériau intrinsèque $n_i$ par la concentration des porteurs du matériau dopé $n_{ie}$ dans les équations de transport de courant. La relation entre $n_i$ et $n_{ie}$ est donnée par l'expression suivante:

$$n_{ie}^2 = n_i^2 \exp (\Delta E_g/kT) \qquad (1)$$

dans laquelle $\Delta E_g$ représente le rétrécissement de l'intervalle des bandes d'énergie, k la constante de Boltzmann et T la température absolue. L'équation indiquée ci-dessus implique que dans le modèle, l'intervalle des bandes d'énergie change en fonction de la concentration mais que la densité effective des états demeurent inchangés. Dans ce modèle, le rétrécissement de l'intervalle des bandes d'énergie des atomes donneurs est ajouté à celui des atomes accepteurs pour obtenir $\Delta E_g$. Cette hypothèse est basée sur l'idée que les bandes d'impuretés s'élargissent autour de l'énergie des niveaux donneurs et accepteurs dans l'intervalle des bandes d'énergie pour des concentrations d'impuretés croissantes.

Les mesures de l'intervalle des bandes d'énergie subordonnées à la concentration de Vol'fson et Subashiev, Soviet Physics-Semiconductors, Volume 1, No 3, Septembre 1967, p. 327, ont été utilisées pour les atomes donneurs et celles de J.W. Slotboom et H.C. de Graaff, Solid-State Electronics, Volume 19, 1976, page 857, ont été utilisés pour les atomes accepteurs. Les mesures de Vol'fson et Subashiev ont été effectuées pour du silicium du type n et du type p en utilisant des techniques d'excitation optiques. Slotboom et de Graaff ont employé un dispositif bipolaire npn pour des mesures effectuées sur du matériau du type p uniformément dopé.

3

Les mesures de l'intervalle des bandes du matériau p utilisé en appliquant ces techniques sont différentes. Etant donné qu'il n'y a pas de mesures de dispositifs bipolaires pour les matériaux de type n , les données de Vol'fson et Subashiev ont été utilisées.

La recombinaison d'Auger basée sur les mesures de durée de vie, subordonnée à la concentration, de Beck et Conrad, Solid State Communication, 13, 93 (1973), ajoutée à la recombinaison de Hall, Schockley-Read, a été également inclue dans les conceptions ci-dessus. Après des calculs réussis de toutes les caractéristiques des dispositifs bipolaires mesurées à température ambiante, des efforts ont été faits en vue de prévoir de nouveaux effets dans des dispositifs bipolaires. Selon la présente invention, on a constaté un tel nouvel effet en ce que les performances du dispositif ($\beta$ et $f_T$) augmentaient d'une manière significative lorsque la compensation dans la zone émetteur était réduite ou supprimée. Van Overstraeten, De Man et Martens, IEEE Transactions on Electron Devices, Volume ED-20, NO. 3, Mars 1973, page 290 et M.S. Mock, Solid-State Electronics, Volume 16, 1973, page 1251 ont calculé l'effet de la concentration intrinsèque en fonction de la concentration du dopant. Certains de leurs résultats abstraits pourraient avoir tendu à impliquer d'une manière lointaine l'influence de la compensation de l'émetteur sur $\beta$. Cependant, nulle part il n'est suggéré qu'il serait souhaitable de réduire la compensation de l'émetteur, ni par quel moyen une telle réduction pourrait être assurée.

Bien que l'on ne puisse pas espérer une précision numérique des résultats calculés en raison des incertitudes présentées par les données publiées et en raison des hypothèses simplificatrices utilisées, les calculs démontrent néanmoins qu'une amélioration significative des performances du dispositif peuvent être réalisées en réduisant la compensation de l'émetteur.

En traitement bipolaire classique, la concentration élevée d'impuretés de compensation dans la région émetteur, est écrasée par le dopant à porteurs majoritaires et n'apparaît donc pas comme contribuant aux performances du dispositif. Cependant, comme indiqué ci-dessus, ces impuretés de compensation peuvent affecter d'une manière significative l'écoulement des porteurs minoritaires et les effets d'emmagasinage de charge dans la région émetteur hautement dopée en raison des effets de rétrécissement de l'intervalle de bandes. En ce qui concerne le développement du dispositif, la présence d'impuretés de compensation indésirables dans la région émetteur peut se révéler nuisible aux performances et au rendement du dispositif pour les raisons suivantes: (1) la formation de défauts susceptibles d'occasioner des fuites, (2) le contrôle imprécis de la diffusion de l'émetteur conduisant à des largeurs de bases variables affectant les valeurs de la résistance de test et la répartition de $\beta$. D'autre part, la région de base extrinsèque qui présente des concentrations élevées d'impuretés du type p , provoquera la formation de défauts pendant le traitement, pouvant piéger des impuretés telles que les impuretés du type métallique loin de la base intrinsèque et ainsi améliorer le rendement. Ainsi, le rendement et la répartition des paramètres des dispositifs doivent être améliorés par la réduction de la compensation de l'émetteur.

5

## Exposé de l'invention

La présente invention concerne un dispositif semi-conducteur à gain en courant continu, fréquence $f_T$ et rendement améliorés sans affectation de ses autres propriétés désirées. Le semi-conducteur de la présente invention présente une couche qui contient des impuretés actives d'un premier type sur un substrat lui-même contenant des impuretés actives d'un deuxième type, au moins une région émetteur contenant des impuretés actives du premier type et moins de $10^{18}$ atomes par $cm^3$ et dans la plus grande partie de la région émetteur moins de $10^{17}$ atomes par $cm^3$ d'impuretés actives d'un second type, au moins une région base intrinsèque contenant des impuretés actives d'un second type opposé au premier type, au moins une région base extrinsèque contenant des impuretés actives d'un second type opposé au premier type, au moins une région collecteur contenant des impuretés actives du premier type et des interconnexions électriques aux contacts électriques du type métallique à conductivité élevée à chacune des régions émetteur, base extrinsèque et collecteur.

La présente invention concerne également un procédé de fabrication d'un dispositif semi-conducteur à gain de courant, fréquence $f_T$ et rendement améliorés qui, cependant, n'affectent pas de manière défavorable les autres caractéristiques désirées du dispositif semi-conducteur. Le procédé comprend la réalisation d'une couche qui contient des impuretés actives d'un premier type sur un substrat contenant lui-même des impuretés actives d'un deuxième type, la réalisation d'au moins une région collecteur contenant des impuretés actives du premier type, l'implantation ionique d'impuretés actives d'un deuxième type opposé au premier dans au moins une région prédéterminée de ladite couche pour obtenir au moins une région de base intrinsèque, la réalisation sélective d'impuretés actives d'un deuxième type opposé au premier type dans au moins une région prédéterminée de la couche pour obtenir au moins une région base extrinsèque tout en masquant au moins une région qui devra être la région émetteur, la réalisation d'au moins une région émetteur contenant des impuretés actives du premier type et moins de $10^{18}$ atomes par $cm^3$ et dans la plus grande partie de ladite région, moins de $10^{17}$ atomes par $cm^3$ d'impuretés actives du second type, et la réalisation d'une configuration d'interconnexions électriques métalliques à conductivité élevée assurant le contact électrique avec les régions collecteur, émetteur et base.

D'autres objets, caractéristiques et avantages de la présente invention ressortiront mieux de l'exposé qui suit, fait en référence aux dessins annexés à ce texte, qui représentent un mode de réalisation préféré de celle-ci.

Brève description des figures des dessins

Les Figures 1A à 1E sont des vues en coupe d'un dispositif bipolaire au cours de diverses étapes de fabrication.

La Figure 2 est une représentation graphique du gain de courant $\beta$ et de la fréquence $f_T$ calculés en fonction de la compensation dans l'émetteur.

La Figure 3 représente les courbes utilisées pour les calculs des concentrations d'impuretés de la Figure 2 en fonction de la profondeur.

7

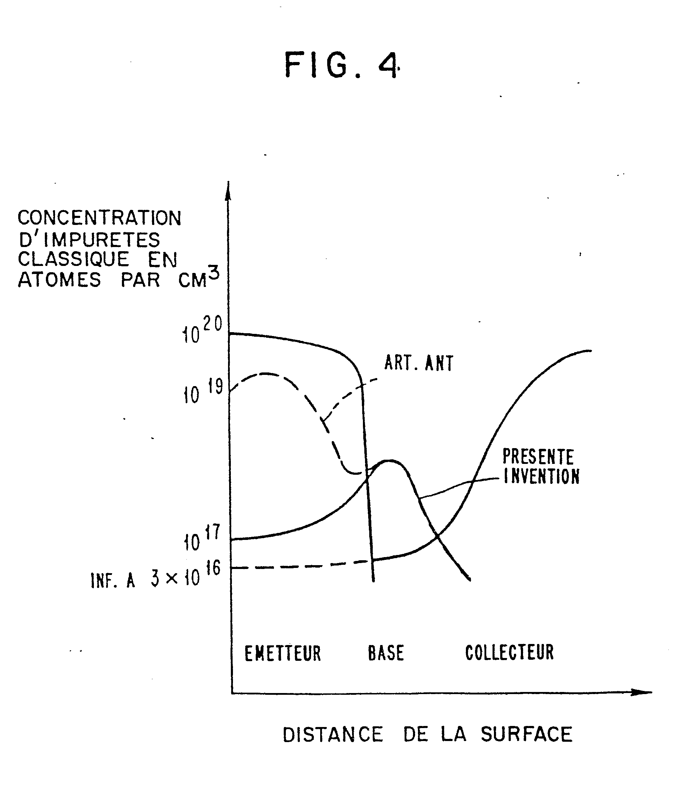

La Figure 4 représente et compare la courbe des concentrations d'impuretés dans la région émetteur proposée par la présente invention à celle utilisée pour les transistors bipolaires implantés de l'art antérieur.

Exposé d'un mode de réalisation

Les dispositifs semi-conducteurs particuliers qui sont fabriqués selon les enseignements de la présente invention sont des dispositifs transistors bipolaires qui contiennent au moins une région émetteur, au moins une région collecteur, au moins une région base extrinsèque et au moins une région base intrinsèque.

Pour la description du procédé de fabrication de la présente invention, on utilisera la terminologie habituelle connue de l'homme de l'art. En ce qui concerne les concentrations, on parlera de porteurs majoritaires ou minoritaires. Par "porteurs", on entend des trous ou électrons qui permettent le passage du courant dans un matériau semi-conducteur. Les porteurs majoritaires désignent dans la description qui va suivre les trous dans le matériau de type p ou les électrons du matériau de type n . Les porteurs minoritaires désignent les trous du matériau de type n ou les électrons du matériau de type p . Dans les types les plus communs de matériaux semi-conducteurs utilisés pour former la structure des transistors actuels, la concentration des porteurs dépend généralement de "l'impureté significative", c'est-à-dire des impuretés qui communiquent au matériau semi-conducteur extrinsèque des caractéristiques de conductivité.

Sauf indication contraire, lorsque l'on parlera d'une impureté du "premier type" et d'une impureté du "deuxième type" on entendra par "premier type", l'impureté

8

concernant un matériau du type n ou p et par "deuxième type", une impureté concernant le deuxième matériau. C'est-à-dire que si le "premier type" est p, le deuxième type sera n. Si le premier type est n, le deuxième type sera p. Lorsque l'on parlera par exemple d'une région contenant une concentration d'impuretés du type, l'impureté significative sera du type p et la majorité des porteurs seront des trous.

Pour plus de facilité, la description des différentes étapes de fabrication sera faite en considérant un mode préféré de celle-ci qui prévoit l'utilisation d'une couche de silicium de type n déposée sur un substrat de silicium de type p et d'impuretés du type p comme régions de base extrinsèque et intrinsèque. Ceci conduit à la réalisation d'un transitor npn. En conséquence, il est évident qu'une couche du type p sur un substrat du type n et des impuretés de dopage des régions de base extrinsèque et intrinsèque du type n peuvent être utilisés selon la présente invention pour la fabrication de transistors du type pnp.

Il est évident que lorsque l'on parle d'impuretés du type n, les différentes étapes du procédé peuvent être appliquées à des impuretés du type p et vice versa. De plus, la présente invention peut être appliquée à des matériaux autres que le silicium qui est le matériau préféré, par exemple au germanium et aux composés III-V tels que l'arséniure de gallium et l'antimoniure d'indium.

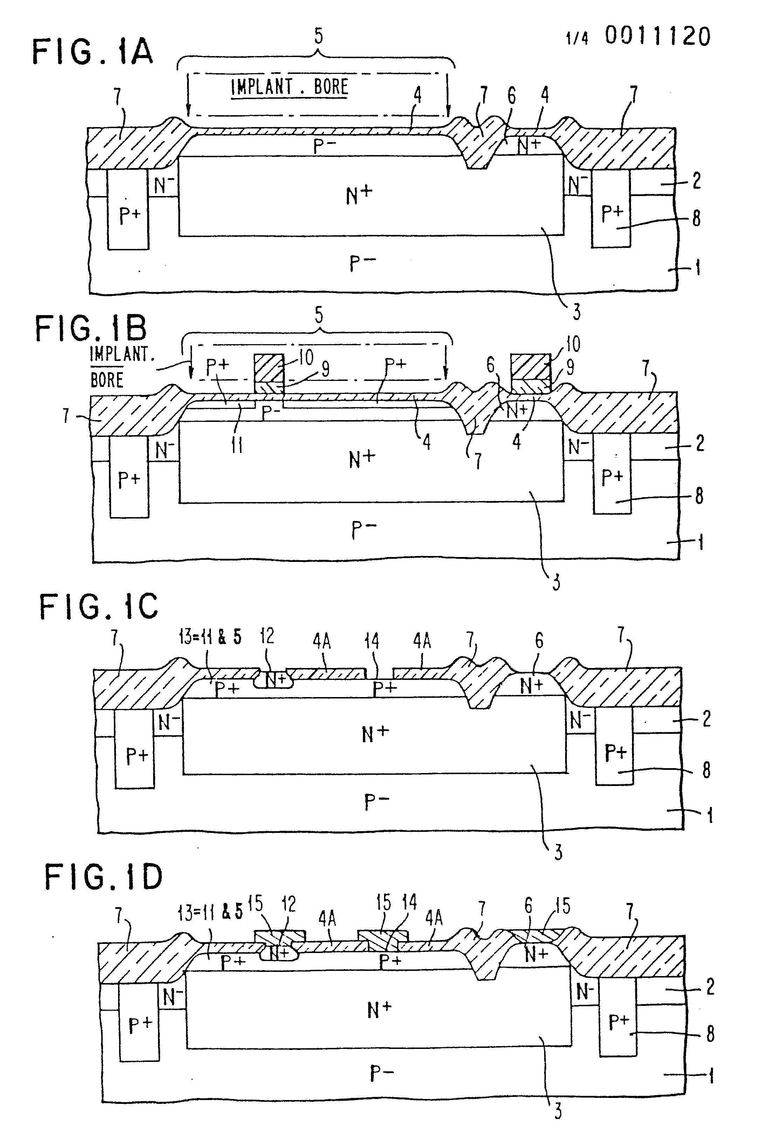

La Figure 1A représente un substrat de silicium du type p se présentant sous la forme d'une pastille dont l'orientation des cristaux est conforme à celle désirée (par exemple <100>).

Le substrat de silicium 1 subit une oxydation thermique permettant la croissance d'approximativement 5000 angstroms d'oxyde et la région n+3 est formée par l'application de techniques photolithographiques et de décapage classiques. La formation de la région n+3 est complétée par la diffusion thermique d'une impureté du type n telle que de l'arsenic, du phosphore, de l'antimoine ou autre matériau similaire, au travers de la fenêtre décapée. On préfère utiliser de l'arsenic pour former la région 3 qui fera fonction de sous-collecteur enterré. Afin de réduire la résistance en série du transistor npn, la concentration initiale d'arsenic devra être de $6 \times 10^{19}$ à $2 \times 10^{20}$ atomes par $cm^3$. D'une manière similaire, la région de sous-isolation enterrée p+8 est formée dans le substrat 1 par l'application de procédés photolithographiques et de décapage classiques suivis par la diffusion thermique d'une impureté du type p, tel que du bore, de l'aluminium, du gallium ou autre matériau similaire. Pour des raisons bien connues de l'homme de l'art, on préfère utiliser du bore pour former la région 8 avec une concentration initiale de $10^{18}$ à $3 \times 10^{19}$ atomes par $cm^3$.

On fait croître ou l'on dépose une couche épitaxiale du type n2 sur les régions n+3 et p+8. L'épaisseur de cette couche épitaxiale peut être généralement de l'ordre de 1 à 3 microns avec une concentration de dopage $\leq 10^{16}$ atomes par $cm^3$. Pendant le dépôt de la couche épitaxiale 2, des impuretés du type n et du type p, respectivement, rétrodiffusent dans la couche épitaxiale à partir des régions 3 et 8. Les régions d'isolation 7, par exemple en oxyde de silicium, peuvent être formées par l'application de l'un quelconque des nombreux procédés bien connus y compris par oxydation thermique de la couche épitaxiale aux régions 7 ou par l'application des procédés de dépôt chimiques en phase vapeur ou sous vide. L'épaisseur des régions d'isolation oxydées 7 est généralement de l'ordre de 4000 à 10000 angstroms. La Figure 1A présente également les régions de contact de collecteur n+6 qui sont formées par diffusion thermique ou implantation ionique d'impuretés du type n tels que de l'arsenic, de l'antimoine et du phosphore. Pour réduire à nouveau la résistance en série des régions de collecteur, la concentration initiale est maintenue entre $10^{19}$ et $10^{20}$ atomes par $cm^3$. Les procédés appliquées pour faire croître une couche épitaxiale, former une isolation d'oxyde et fabriquer une région de contact de collecteur sont bien connus de l'homme de l'art.

La couche d'oxyde 4 est obtenue par oxydation thermique de la couche épitaxiale 2 et présente une épaisseur de 1000 à 1600 angstroms. Une région 5 est formée par l'application de procédés de masquage lithographiques et de décapage bien connus. Une impureté du type p est ensuite implantée dans cette région 5 pour former la région de base intrinsèque ou région de base profonde comme on l'appelle quelquefois dans l'art antérieur. La région de base intrinsèque peut également être considérée comme la région de base active et est à un niveau inférieur à la région émetteur qui doit être formée ensuite. Le bore peut être considéré comme un matériau de dopage du type p préféré. Pour l'implantation une énergie de l'ordre de 150 KeV avec un dosage de $10^{13}$ par $cm^2$ est classique pour du bore. D'autres matériaux de dopage du type p pour le silicium pourrait être l'aluminium, le gallium et l'indium. En appliquant un procédé d'implantation ionique pour doper la région de base intrinsèque, la compensation dans la région émetteur à former ultérieurement peut être et est inférieure à $10^{18}$ atomes par $cm^3$ et sur la plus grande partie de ladite région (par exemple, sur au moins 50% de ladite région), maintenue à un niveau inférieur à $10^{17}$ atomes par $cm^3$ ou moins pour obtenir un gain en courant continu ($\beta$), une fréquence $f_T$ et un rendement améliorés du transistor sans affecter de manière défavorable ses autres propriétés électriques désirées. En fait, l'une des caractéristiques principales de la présente invention est de permettre l'élimination de toute compensation de la région émetteur.

La région de base intrinsèque contient généralement de l'ordre de $5 \times 10^{16}$ à $2 \times 10^{18}$, et de préférence de $10^{17}$ à $10^{18}$ atomes de dopant par $cm^3$.

Bien que les procédés d'implantation ionique soient bien connus dans l'art antérieur, il n'est pas apparu jusqu'à maintenant que la compensation dans la plus grande partie de la région émetteur d'un dispositif bipolaire, devait être limité à une valeur ne dépassant pas $10^{17}$ atomes par $cm^3$ approximativement, pour obtenir un gain en courant continu et une fréquence de largeur de bande de gain en courant améliorés. A ce sujet, on peut se reporter à l'article de Reddi et al, "Ion Implantation for Silicon Device Fabrication", Solid State Technology, Octobre 1972 et de Lepselter, "Ion Implantion-Impact on Device Fabrication", 1972. Il n'existe aucun essai délibéré connu exécuté dans l'art antérieur et portant sur l'utilisation de l'implantation ionique dans ce but. Les deux articles indiqués ci-dessus suggèrent des structures dans lesquelles la région de base intrinsèque n'est formée que par l'application d'une technique d'implantation ionique profonde (par exemple, voir la Figure 11 de l'article de Reddi et al et la Figure 16 de l'article de Lepselter). Cependant, ces articles ne mentionnent aucune recon-

0011120

naissance de la relation existant entre l'importance de la compensation dans la région émetteur et les caractéristiques de gain en courant du transistor. De plus, la technique décrite par Reddi et al et plus particulièrement à la Figure 11, ne permet pas de réaliser une région émetteur faiblement compensée. La séquence d'étapes décrite dans cet article permet d'obtenir une région de base inactive ou extrinsèque par application d'une technique de diffusion. Cependant, on ne trouve pas de suggestion explicite du masquage de la région émetteur pendant la diffusion. On ne peut pas supposer la réalisation de ce masquage étant donné qu'il était au contraire, généralement pratiqué par l'homme de l'art à ce moment là (1972), d'assurer une opération de diffusion sur toute la zone s'étendant d'une extrémité à l'autre de la région de base inactive, englobant ainsi la région émetteur à former ultérieurement. Il n'y a rien dans l'art antérieur qui puisse suggérer à l'homme de l'art qu'il trouverait un avantage quelconque à protéger la région émetteur contre un dopage par la région de base inactive. L'art antérieur ignorait les inconvénients que pouvait engendrer la présence d'une quantité d'impuretés de compensation dans la région émetteur excédant la quantité critique requise par la présente invention. De plus, le dispositif présenté dans l'article de Reddi et al ne comporterait pas de région émetteur auto-alignée ou auto-correspondante par rapport à la région de base extrinsèque comme celle obtenue par l'application du procédé de la présente invention. Une correspondance imparfaite de la base extrinsèque par rapport à la région émetteur provoquerait une compensation indésirable d'une partie de la région émetteur et une résistance de base extrinsèque élevée. En ce qui concerne l'article de Lepselter, la partie concernant l'implantation de la région de base profonde ou base intrinsèque ne donne pas de détails précis en ce qui concerne la Figure 16. Cependant, une description de la région de base profonde implantée à la page 850 avec référence aux Figures 12 et 13, traite de l'utilisation d'un double implant gaussien entraînant une compensation élevée dans la région émetteur et ne permettant donc pas d'atteindre une compensation de l'ordre de $10^{17}$ atomes par $cm^3$ ou moins, comme désiré dans la présente invention. De plus, étant donné que l'on ne connaissait à cette époque aucun inconvénient incitant à maintenir un niveau de compensation d'impuretés bas dans la région émetteur, il n'y avait pas de raison de le faire.

La présente invention implique également peu et, de préférence, pas du tout de compensation de la région base intrinsèque par la région émetteur, comme pratiqué dans l'art antérieur.

L'une des caractéristiques les plus avantageuses de la présente invention est d'avoir une région émetteur pratiquement exempte de toute compensation et dont le seul dopant est constitué par des impuretés du premier type. Une couche de barrière à l'oxydation adhérente 9 dans la Figure 1B, composée d'un matériau non-oxydant tel que du nitrure de silicium, du nitrure d'aluminium, du nitrure de bore ou de l'oxyde d'aluminium est alors déposée. De préférence, la couche 9 est composée de nitrure de silicium et présente une épaisseur d'approximativement 500 à 1500 angstroms. La couche peut être déposée par l'application de techniques de dépôt chimique en phase vapeur ou par pulvérisation. Une couche d'un matériau photo-résistant 10 tel que celui du type utilisé lors de l'application des techniques de masquage lithographique et de décapage connues est placée sur la surface de la couche de barrière à l'oxydation 9. Par exemple, l'un quelconque des matériaux résistants photo-sensibles polymérisables connus dans l'art antérieur pourrait être utilisé. La matériau résistant peut être appliqué par pulvérisation ou par centrifugation. La couche de matériau photo-résistant 10 est séchée, puis sélectivement exposée à une radiation UV au travers d'un masque photo-lithographique formé d'un matériau transparent à parties opaques disposées selon une configuration prédéterminée. La pastille masquée est soumise à la lumière UV qui polymérise les parties du matériau photo-résistant se trouvant sous les régions transparentes du masque. Cette opération laisse un recouvrement de matériau photo-résistant sur la région où l'émetteur sera ultérieurement formé.

Après le retrait du masque, la pastille est rincée dans une solution de développement appropriée qui retire toutes les parties du matériau résistant se trouvant sous les régions transparentes du masque. L'ensemble peut alors être cuit pour mieux polymériser et durcir le matériau résistant restant qui est conforme à la configuration désirée, c'est-à-dire qu'il recouvre la région dans laquelle les zones émetteur seront ultérieurement formées. Il recouvre également les régions de contact de collecteur 6 comme on le voit dans la Figure 1B.

Puis la structure est traitée pour retirer les parties de la couche de nitrure de silicium 9 non protégées par le matériau résistant 10, par application d'une technique de décapage à sec (c'est-à-dire par décapage ionique réactif), par exemple en utilisant du $CF_4$.

La région base extrinsèque 11 qui est quelquefois appelée région base peu profonde, est ensuite formée par exemple par diffusion ou de préférence par implantation ionique. Un matériau de dopage du type p tel que du bore est implanté dans les régions 11 comme on le voit sur la Figure et les ions peuvent être entraînés ou diffusés plus loin (par exemple à une profondeur de l'ordre de 500 à 2000 angstroms) dans le substrat par chauffage à une température de l'ordre de 1000°c pendant approximativement 30 minutes. Un exemple classique d'implantation de bore a une énergie de l'ordre de 50 KeV avec une dose d'approximativement $10^{14}$ par $cm^2$. Les couches 9 et 10 font fonction de masques pour déterminer les régions du substrat dans lesquelles le matériau de dopage du type p est implanté. La couche de barrière à l'oxydation 9 et le matériau photo-résistant 10 interdisent au matériau de dopage du type p de pénétrer dans la région émetteur qui sera formée ultérieurement et la région de contact de collecteur 6 pendant l'implantation ionique de la région base extrinsèque.

En général, le dopage de la base extrinsèque est de l'ordre de $10^{18}$ à $10^{19}$ atomes de matériau de dopage par $cm^3$. La région de base extrinsèque 11 est nécessaire pour assurer un bon contact à la région base et pour réduire la résistance de la base. Le dopage dans la région base extrinsèque de la présente invention plus important que dans la région base intrinsèque permet d'ontenir les avantages de la présente invention.

Le masque photo-résistant 10 est retiré des zones de nitrure de silicium 9 par application d'un solvant approprié. On fait croître thermiquement une épaisseur de l'ordre de 1000 à 5000 angstroms d'oxyde de silicium 4A sur toute la surface du dispositif à l'exception des régions couvertes de nitrure de silicium (voir la Figure 1C). Le nitrure de silicium 9 est retiré par décapage dans une solution d'acide phosphorique à approximativement 180°c. Si on le désire, une partie de l'épaisseur totale de la couche de di-oxyde peut être retirée (par exemple pour obtenir une épaisseur de l'ordre de 1000 angstroms) par rinçage de décapage dans du HF tamponné.

La région émetteur 12 est alors formée par exemple par diffusion ou de préférence par implantation ionique d'impuretés du type n dans la ou les régions précédemment recouvertes par la couche de nitrure de silicium 9. La couche d'oxyde 4A fait fonction de masque pour interdire la pénétration des impuretés du type n dans la région base extrinsèque. L'impureté de type n est formée de phosphore ou de préférence d'arsenic et est généralement utilisée à la concentration d'au moins environ $10^{19}$ atomes par $cm^3$ et de préférence à la concentration d'au moins environ $10^{20}$ atomes par $cm^3$. Une concentration de matériau de dopage dépassant $2 \times 10^{20}$ atomes par $cm^3$ n'est généralement pas nécessaire lorsque l'on utilise de l'arsenic. L'utilisation d'une concentration de phosphore atteignant approximativement $10^{21}$ atomes par $cm^3$ s'est révélée tout à fait appropriée. On préfère utiliser de l'arsenic en raison de ses propriétés de diffusion qui permettent d'obtenir facilement la formation de jonctions peu profondes et abruptes. De plus, la région émetteur présente généralement une épaisseur de l'ordre de 1000 angstroms à environ 1 micron et de préférence de l'ordre de environ 2000 à environ 8000 angstroms. Comme indiqué au cours du déroulement de cette séquence d'opérations, les limites entre la région émetteur et la région base extrinsèque sont auto-alignées.

Puis des parties prédéterminées 14 de la couche d'oxyde de silicium sont retirées pour révéler les régions de base extrinsèques (Figure 1C). Ces parties prédéterminées de la couche d'oxyde de silicium peuvent être retirées par l'application d'une couche de matériau photo-résistant à l'assemblage. Les matériaux photorésistants sont alors exposés à une radiation UV en utilisant une configuration de masquage prédéterminée et les régions exposées du matériau photo-résistant sont alors dissoutes. Puis, la structure est traitée pour retirer les parties de la couche d'oxyde de silicium non protégées par le matériau résistant, par exemple par immersion dans un solvant approprié tel que de l'acide fluorhydrique tamponné. La solution de décapage dissout l'oxyde de silicium mais n'attaque pas le matériau résistant ou les autres matériaux de l'ensemble. La couche de matériaux photo-résistant au-dessus de l'oxyde de silicium restant, peut alors être retirée par dissolution dans un solvant approprié.

Maintenant que les régions de base et les régions émetteur sont exposées pour réalisation du contact une configuration de lignes d'interconnexion du type métallique à conductivité élevée 15 (Figure 1D), un métal de préférence, est déposée et la configuration d'interconnexion est délimitée. On peut citer à titre d'exemple de matériau hautement conducteur et utilisé cou-ramment dans les interconnexions, l'aluminium qui peut contenir des quantités relativement faibles d'impuretés à introduire afin de diminuer les effets d'électro-migration ou d'éviter ou de réduire les réactions chimiques entre l'aluminium et le matériau semi-conducteur à contacter. Les matériaux hautement conducteurs tels que l'aluminium peuvent être déposés par pulvérisation ou de préférence, par évaporation. Les expressions "lignes d'interconnexion du type métallique" ou "lignes d'interconnexion à conductivité élevée" concernent des lignes métalliques, par exemple en aluminium, ainsi que des lignes non-métalliques (par exemple en siliciures inter-métallique ou en poly- silicium hautement dopé, présentant néanmoins des conductivités de l'ordre de celles généralement possédées par les métaux conducteurs).

De plus, comme dans l'art antérieur, d'autres couches (non représentées) peuvent être déposées sur les couches du type métallique, par exemple du dioxyde de silicium pulvérisé pour passiver le circuit intégré. Toujours comme dans l'art antérieur, si on le désire, d'autres étapes de masquage peuvent être exécutées pour former des passage au travers de la couche de passivation pour assurer le contact avec la couche d'interconnexion métallique ou le substrat semi-conducteur.

La séquence indiquée ci-dessus et utilisée pour fabriquer le dispositif de la présente invention est décrite de manière générale par W.P. Dumke dans l'IBM Technical Disclosure Bulletin, Vol. 20, No 7, Décembre 1977, dans l'article intitulé "Self-Registered Technique for Avoiding Compensation from the Shallow Base Implant in the Emitter Region of a Bipolar Transistor" et par G. Das, A.K. Gaind, R.K. Raheja et A. Sugermam dans l'IBM Technical Disclosure Bulletin, Vol. 21, No 2, Juillet 1978 dans l'article intitulé "Fabrication of Base Region of a Transistor Using Two Ion Implantation Steps".

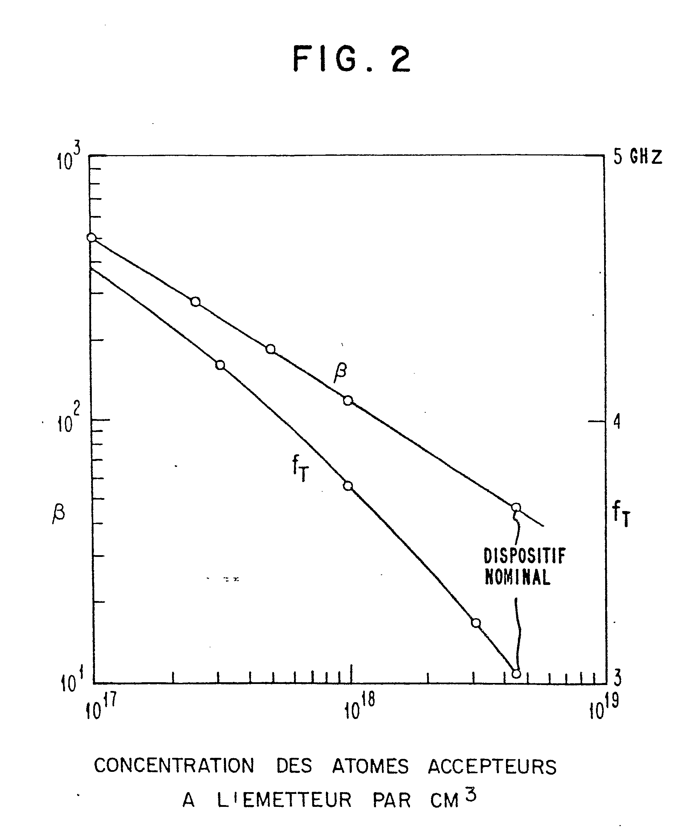

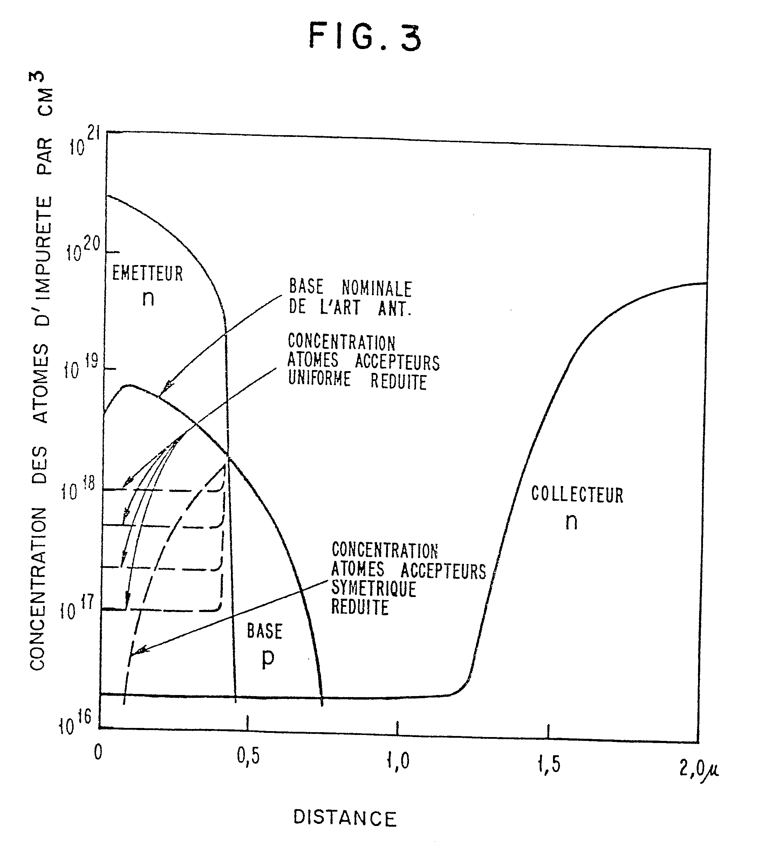

La Figure 2 représente $\beta$ et $f_T$ en fonction du niveau des atomes de compensation ou accepteurs dans l'émetteur d'un dispositif npn. $\beta$ et $f_T$ sont tous deux déterminés par un programme de dispositif bipolaire en une dimension développé par B.W. Gokhale et décrit dans IEEE Trans Electron Devices ED 17594 (1970), programme dans lequel les équations de transport sont résolues par des méthodes numériques. Pour le dispositif nominal représenté à la Figure 3, $\beta$ est de 47. A mesure que le niveau des atomes accepteurs de l'émetteur diminue, β augmente. Les calculs montrent un accroissement de β supérieur à un ordre de grandeur jusqu'à une valeur d'approximativement 500 lorsque la concentration des atomes accepteurs à l'émetteur est ramenée de la valeur du dispositif nominal à $1.0 \times 10^{17}$ atomes par $cm^3$. Le gain en courant a une valeur de 412 en ce qui concerne le dispositif à profil de base symétrique. A mesure que la concentration à l'émetteur décroît, l'intervalle de bande énergétique dans l'émetteur s'élargit, provoquant la diminution du courant de base injecté et ainsi l'augmentation de β. Le courant électronique est constant étant donné que le profil des concentrations donneurs de l'émetteur, et donneurs et accepteurs de la base du collecteur demeurent inchangé.

La courbe de $f_T$ en fonction de la concentration des atomes accepteurs d'émetteur augmente régulièrement d'une manière similaire à celle de β à mesure que la concentration des atomes accepteurs d'émetteur décroît. Les calculs montrent cependant que l'accroissement de $f_T$ n'est pas aussi important que celui de β pour une compensation d'émetteur réduite. La fréquence $f_T$ du dispositif nominal est de 3,03 GHZ et le dispositif de base symétrique a une fréquence $f_T$ de 4,0 GHZ.

La Figure 3 représente les effets de la présente invention. Le profil illustré du dispositif est similaire à celui d'un transistor bipolaire moderne à performance élevée et présente une compensation décroissant par paliers. Dans les profils de compensation réduite, les atomes accepteurs ou de compensation dans l'émetteur sont uniformes de la surface à la région précédant juste la couche d'appauvrissement, après quoi ils rejoignent régulièrement le profil de base nominal. Le nombre de Gummel, le champ électrique de la jonction

20

émetteur et les profondeurs des jonctions émetteur et
collecteur sont inchangés avec ces profils. En conséquence, toute modification des performances du dispositif est attribuée à des modifications de la compensation. Ces profils idéalisés peuvent ne pas être
réalisables nécessairement en appliquant les procédé
actuels de fabrication des dispositifs en laboratoire.
Ils permettent simplement et directement de démontrer
l'influence de l'abaissement de la compensation émetteur sur les performances des dispositifs bipolaires
dans une situation idéale. On considère également un
autre profil de base présentant un profil de concentration symétrique aux côtés émetteur et base de la
jonction émetteur. Les résultats du programme décrit
ci-dessus sont représentés à la Figure 2. Comme on le
voit à la Figure 3, la compensation dans la région de
l'émetteur est réduite d'une manière significative sans
modification du nombre de Gummel, ce qui est important
pour la caractérisation de $\beta$ et $f_T$ du dispositif. Le
nombre de Gummel concerne le dopant majoritaire dans la
région de base intrinsèque. La région base intrinsèque
est la région de base active en ce qui concerne la
commande du dispositif.

La présente invention permet également de réaliser des
dispositifs améliorés pour fonctionnement à basse
température (par exemple aux alentours de 25°c). De
plus, la fabrication actuelle des dispositifs bipolaires
effectuée selon les enseignements de la présente invention permet d'obtenir de meilleurs $\beta$ le long des
lignes comme montré par les Figures 2 et 3 décrites ci-
dessus et dans le tableau ci-dessous:

TABLEAU I

| Dispositif | Paramètres des dispositifs | | | | |
|---|---|---|---|---|---|
| | $Bv_{ebo}(v)$ | $Bv_{cbo}(v)$ | $Bv_{ces}(v)$ | $R_{db}(k\Omega/\square)$ | $\beta$ |
| Présente Invention | 4,8 | 25 | 25 | 8,2 | 160 |
| Dispositif Classique | 4,5-5,5 | 15-28 | 15-28 | 8 | 80-90 |

Ainsi, $\beta$ a été doublé à température ambiante. De plus, les fuites ne réduisent les rendements que de moins de 10% et les paramètres du dispositif sont très uniformes et répartis d'une manière très serrée. Bien que le rendement élevé puisse être attribué à l'absence de défauts résultant en fuites et à l'élimination des impuretés de compensation, cette dernière caractéristique est dûe au profil de diffusion précis de l'émetteur obtenu lorsque les effets de dopage importants gênants ont été réduits.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

REVENDICATIONS

1.- Dispositif semi-conducteur à gain de courant amélioré caractérisé en ce qu'il comprend:

une couche contenant des impuretés actives d'un premier type que l'on a faite épitaxialement croître sur un substrat contenant des impuretés actives d'un deuxième type,

au moins une région émetteur dans ladite couche contenant des impuretés actives d'un premier type et moins de $10^{18}$ atomes par $cm^3$ et sur la plus grande partie de ladite région, moins de $10^{17}$ atomes par $cm^3$ d'impuretés actives d'un deuxième type opposé au premier type,

au moins une région base intrinsèque dans ladite couche contenant des impuretés actives d'un deuxième type opposé audit premier type,

au moins une région base extrinsèque dans ladite couche contenant des impuretés actives d'un deuxième type opposé audit premier type,

au moins une région collecteur dans ladite couche contenant des impuretés actives d'un premier type,

et des connexions électriques entre des interconnexions électriques du type métallique à conductivité élevée et chacune desdites régions émetteur, région base extrinsèqe et région collecteur.

2.- Dispositif selon la revendication 1, caractérisé en ce que ladite région émetteur est pratiquement
exempte d'impuretés actives dudit deuxième type.

3.- Dispositif selon la revendication 1 ou 2, caractérisé en ce que ladite impureté dudit premier type
est une impureté du type n.

4.- Dispositif selon l'une des revendications 1 à 3,
caractérisé en ce que ladite base intrinsèque
contient entre environ $5x10^{16}$ et environ $2x10^{18}$
atomes d'impuretés dudit deuxième type par $cm^3$.

5.- Dispositif selon l'une des revendications 1 à 4,
caractérisé en ce que ladite base extrinsèque
contient entre environ $10^{18}$ et environ $5x10^{19}$
atomes d'impuretés dudit deuxième type par $cm^3$.

6.- Dispositif selon l'une des revendications 1 à 5
caractérisé en ce que ladite région émetteur
contient au moins environ $10^{19}$ atomes d'impuretés
dudit premier type par $cm^3$.

7.- Dispositif selon l'une des revendications 1 à 6,
caractérisé en ce que ladite région émetteur et
ladite région base extrinsèque sont auto-alignées
l'une par rapport à l'autre.

8.- Dispositif selon l'une des revendications 1 à 7,
caractérisé en ce que ladite région base intrinsèque est pratiquement exempte de compensation par
ladite région émetteur.

9.- Procédé de fabrication d'un dispositif semi-
conducteur à gain de courant, fréquence $f_T$ et
rendement améliorés, caractérisé en ce qu'il
comprend les étapes suivantes:

a)    la formation d'une couche contenant des impuretés actives d'un premier type sur un substrat contenant des impuretés actives d'un deuxième type,

b)    la formation d'au moins une région collecteur contenant des impuretés actives dudit premier type,

c)    l'implantation ionique d'impuretés actives d'un deuxième type opposé audit premier type dans ladite couche pour former au moins une région base intrinsèque,

d)    l'introduction d'impuretés actives d'un second type opposé audit premier type dans au moins une région prédéterminée de ladite couche pour former au moins une région base extrinsèque, tout en masquant au moins une région qui deviendra au moins une région émetteur,

e)    la formation d'au moins une région émetteur contenant des impuretés actives dudit premier type et au mieux, approximativement $10^{17}$ atomes par $cm^3$ d'impuretés actives dudit deuxième type, et

f)    la formation d'une configuration d'interconnexions électrique du type métallique à conductivité élevée assurant un contact électrique ohmique auxdites région collecteur, région émetteur et région base extrinsèque.

10.- Procédé selon la revendication 9, caractérisé en ce qu'il comprend une étape d'implantation ionique d'impuretés du deuxième type pour former ladite région base extrinsèque et une étape d'implantation ionique d'impuretés dudit premier type pour former ladite région émetteur.

# FIG. 1A

FIG. 1A

5
IMPLANT. BORE
4    7  6  4    7
7         P⁻
N⁻      N⁺
P+      N⁺      N⁻  2
P+      8
3       P⁻      1

# FIG. 1B

FIG. 1B

5
IMPLANT. BORE
P+  10  9  P+
7      11  P⁻      6  10 9  7
7   P+  N⁻      4   N⁺  4  N⁻  2
N⁺      P+  8
3      P⁻      1

# FIG. 1C

FIG. 1C

7   13=11 & 5  12  4A  14  4A  7  6  7
P+  N⁻  P+  N⁺  P+  N⁺  N⁻  2
P+  8
N⁺
3   P⁻  1

# FIG. 1D

FIG. 1D

7   13=11 & 5  15 12  4A  15 14  4A  7  6  15  7
P+  N⁻  P+  N⁺  P+  N⁺  N⁻  2
P+  8
N⁺
3   P⁻  1

# FIG. 2

CONCENTRATION DES ATOMES ACCEPTEURS
A L'EMETTEUR PAR CM$^3$

FIG.3

# FIG. 4

CONCENTRATION
D'IMPURETES
CLASSIQUE EN
ATOMES PAR CM$^3$

$10^{20}$

$10^{19}$

ART. ANT

PRESENTE
INVENTION

$10^{17}$

INF. A $3 \times 10^{16}$

EMETTEUR          BASE          COLLECTEUR

DISTANCE DE LA SURFACE

# RAPPORT DE RECHERCHE EUROPEENNE

Office européen des brevets

**0011120**
Numéro de la demande

EP 79 103 769.0

## DOCUMENTS CONSIDERES COMME PERTINENTS

| Catégorie | Citation du document avec indication, en cas de besoin, des parties pertinentes | Revendication concernée |
|---|---|---|
| | DE - B2 - 1 614 264 (PHILIPS') <br> * revendication 13; colonne 12, ligne 62 à colonne 13, ligne 68; fig. 1 à 4 * <br> -- | 1,3-5 |
| | FR - A - 2 212 645 (SONY) <br> * page 5, lignes 18 à 39; fig. 2 * <br> & US - A - 4 007 474 <br> -- | 1 |
| D | SOLID STATE TECHNOLOGY, Octobre 1972, Washington <br> V.G.K. REDDI et al. "Ion Implantation for Silicon Device Fabrication" <br> * pages 35 à 41 * <br> -- | |
| D | IBM TECHNICAL DISCLOSURE BULLETIN, Vol. 20, No. 7, Decembre 1977 New York <br> W.P. DUMKE "Self-registered technique for avoiding compensation from the shallow base implant in the emitter region of a bipolar transistor" <br> pages 2881 à 2882 <br> * pages 2881 à 2882; fig. 1 à 4 * <br> -- | |
| D,A | SOLID-STATE ELECTRONICS, Vol. 16, 1973 Oxford <br> M.S. MOCK "Transport equations in heavily doped silicon, and the current gain of a bipolar transistor" <br> * pages 1251 à 1259 * <br> -- ./.. | |

**CLASSEMENT DE LA DEMANDE (Int. Cl.3)**

H 01 L 29/72
H 01 L 29/36

**DOMAINES TECHNIQUES RECHERCHES (Int. Cl.3)**

H 01 L 29/36
H 01 L 29/72

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons
&: membre de la même famille, document correspondant

Le present rapport de recherche a été établi pour toutes les revendications

| Lieu de la recherche | Date d'achevement de la recherche | Examinateur |
|---|---|---|
| Berlin | 05-02-1980 | ROTHER |

OEB Form 1503.1  06.78

Office européen
des brevets

**RAPPORT DE RECHERCHE EUROPEENNE**

| Catégorie | Citation du document avec indication, en cas de besoin, des parties pertinentes | Revendication concernée | CLASSEMENT DE LA DEMANDE (Int. Cl.³) |
|---|---|---|---|
| | **DOCUMENTS CONSIDERES COMME PERTINENTS** | | |
| A | SOLID-STATE ELECTRONICS, Vol. 17, 1974 Oxford R.B. FAIR "Cooperative effects between arsenic and boron in silicon during simultaneous diffusions from ion implanted and chemical source predepositions" * pages 17 à 24 * -- | | |
| A | SOLID-STATE ELECTRONICS, Vol. 17, No. 8, 1974 Oxford M.S. MOCK "On heavy doping effects and the injection efficiency of silicon transistors" * pages 819 à 824 * -- | | DOMAINES TECHNIQUES RECHERCHES (Int. Cl.³) |
| D,A | SOLID-STATE ELECTRONICS, Vol. 19, 1976 Oxford J.W. SLOTBOOM et al. "Measurements of bandgap narrowing in Si bipolar transistors" * pages 857 à 862 * -- | | |
| D,A | SOLID STATE COMMUNICATIONS, Vol. 13, 1973 Oxford J.D. BECK et al. "Auger-rekombination in Si" * pages 93 à 95 * -- ./.. | | |

OEB Form 1503.2 06.78

**Office européen des brevets**

## RAPPORT DE RECHERCHE EUROPEENNE

| | DOCUMENTS CONSIDERES COMME PERTINENTS | | CLASSEMENT DE LA DEMANDE (Int. Cl.) |
|---|---|---|---|
| Catégorie | Citation du document avec indication, en cas de besoin, des parties pertinentes | Revendica-tion concernée | |
| D,A | IEEE TRANSACTIONS ON ELECTRON DEVICES, Vol. ED-15, No. 10, Octobre 1968 New York L. KAUFFMAN et al. "The Temperature Dependence of Ideal Gain in Double Dif-fused Silicon Transistors" * pages 732 à 735 * -- | | |
| D,A | IEEE TRANSACTIONS ON ELECTRON DEVICES, Vol. ED-17, No. 8, Août 1970 New York B.V. GOKHALE "Numerical Solutions for a One-Dimensional Silicon n-p-n Tran-sistor" * pages 594 à 602 * -- | | **DOMAINES TECHNIQUES RECHERCHES (Int. Cl.)** |
| D,A | IEEE TRANSACTIONS ON ELECTRON DEVICES, Vol. ED-20, No. 3, Mars 1973 New York R.J. VAN OVERSTRAETEN et al. "Transport Equations in Heavy Doped Silicon" * pages 290 à 298 * ---- | | |